# EUROPÄISCHE PATENTANMELDUNG

(11) **EP 2 874 316 A1**
(43) Veröffentlichungstag der Anmeldung: **20.05.2015**
(21) Anmeldenummer: 14192951.3
(22) Anmeldetag: 13.11.2014
(51) Int. Cl.: H03K 17/96

(54) **Berührungssensitiver Schalter für ein Kraftfahrzeug**

(30) Priorität: 13.11.2013 DE 102013018989
(71) Anmelder: Valeo Schalter und Sensoren GmbH, 74321 Bietigheim-Bissingen (DE)
(72) Erfinder: Müller, Otto, 96145 Sesslach (DE)

(57) **Zusammenfassung**

Die Erfindung betrifft einen berührungssensitiven Schalter (1) für ein Kraftfahrzeug, mit einer Abdeckung (2) mit einer berührungssensitiven Oberfläche (4) und mit zumindest einem grafischen Symbol (3), mit einer hinter der Abdeckung (2) angeordneten Trägerplatte (7), auf welcher zumindest ein kapazitives Sensorelement (6) zum Erfassen einer Berührung der berührungssensitiven Oberfläche (4) angeordnet ist, und mit einem Leuchtmittel (10) zum Erzeugen von Licht (11) zum Hinterleuchten der berührungssensitiven Oberfläche (4), wobei das Leuchtmittel (10) insbesondere in einem Abstand zur Trägerplatte (7) angeordnet ist, wobei die Trägerplatte (7) opak ausgebildet ist und eine Mehrzahl von Durchgangsöffnungen (12) aufweist, durch welche hindurch das Licht (11) des Leuchtmittels (10) die berührungssensitive Oberfläche (4) im Betrieb hinterleuchtet.

## Beschreibung

Die Erfindung betrifft einen berührungssensitiven Schalter für ein Kraftfahrzeug, mit einer Abdeckung mit einer berührungssensitiven Oberfläche und zumindest einem graphischen Symbol, mit einer hinter der Abdeckung angeordneten Trägerplatte, auf welcher zumindest ein kapazitives Sensorelement zum Erfassen einer Berührung der berührungssensitiven Oberfläche angeordnet ist, und mit einem Leuchtmittel zum Erzeugen von Licht zum Hinterleuchten der berührungssensitiven Oberfläche. Die Erfindung betrifft außerdem ein Kraftfahrzeug mit einem solchen Schalter.

Berührungssensitive Schalter sind bereits aus dem Stand der Technik in vielfältiger Ausgestaltung bekannt. Vorliegend richtet sich das Interesse auf einen Schalter, mittels welchem Funktionskomponenten eines Kraftfahrzeugs bedient werden können, wie beispielsweise eine Klimaanlage. Solche Schalter weisen üblicherweise eine äußere Abdeckung auf, welche eine berührungssensitive Oberfläche aufweist, die durch die Bedienperson berührt werden kann, um die zugeordnete Funktion zu aktivieren oder deaktivieren oder aber eine zugeordnete Stellgröße einzustellen. Hinter der Abdeckung und somit auf einer der berührungssensitiven Oberfläche gegenüberliegenden Seite der Abdeckung ist üblicherweise eine Trägerplatte angeordnet, welche zumindest ein kapazitives Sensorelement trägt. Mithilfe eines solchen Sensorelements, das üblicherweise als Sensorelektrode ausgebildet ist, wird die Berührung der Oberfläche der Abdeckung detektiert. Hier bildet das kapazitive Sensorelement aus einem elektrisch leitfähigen Material eine erste Kondensatorplatte, während der Finger der Bedienperson die zweite Kondensatorplatte bildet. Beim Berühren der Oberfläche ändert sich somit insgesamt die elektrische Kapazität, was mittels einer entsprechenden Auswerteeinrichtung detektiert werden kann.

Eine solche kapazitive Bedien- und Anzeigeeinheit ist beispielsweise aus dem Dokument DE 10 2010 062 428 A1 bekannt. Die Abdeckung ist hier in Form einer Glaskeramikplatte eines Kochfelds ausgebildet, wobei sich unter der Glaskeramikplatte eng anliegend eine Leiterplatte befindet, die auf der Oberseite mit einer Beschichtung oder Folie mit Lichtstreuwirkung und mit Symboldruck versehen ist. In der Leiterplatte sind Durchgangsöffnungen vorgesehen, und hinter jeder Durchgangsöffnung ist ein Leuchtmittel in Form einer LED angeordnet.

Bei kapazitiven Schaltern für Kraftfahrzeuge werden für die Erfassung der Berührung üblicherweise transparente Träger, wie beispielsweise Folien, Glas, transparente Kunststoffe und dergleichen, mit transparenten leitfähigen Drucken zur Realisierung des Sensorelements eingesetzt. Durch diese Transparenz können die Symbole an der Bedienoberfläche beleuchtet werden. Sowohl die transparenten Träger als auch die entsprechenden Drucke bedeuten jedoch relativ viel Aufwand und Mehrkosten. Eine gewisse Abhilfe schafft hier das oben genannte Dokument DE 10 2010 062 428 A1, bei welchem eine einfache Leiterplatte als Träger für die Sensorelemente eingesetzt wird. Als nachteilig an diesem Stand der Technik hat sich jedoch der Umstand erwiesen, dass die Beleuchtung der berührungssensitiven Oberfläche nicht 100% homogen ist, da sich die einzelnen Leuchtmittel herstellungsbedingt häufig in ihren Leuchteigenschaften voneinander geringfügig unterscheiden.

Ein berührungsempfindlicher Schalter ist außerdem aus dem Dokument DE 101 55 906 A1 bekannt. An einer äußeren Oberfläche ist eine Beschichtung aufgebracht, die lichtundurchlässig ist. Weiter ist an der äußeren Oberfläche auch ein Anzeigeelement, wie eine Beschriftung, ein Symbol, eine Funktionsanzeige oder dergleichen, durch Freilassen oder Entfernen der Beschichtung angebracht. Das Anzeigeelement ist mittels eines der inneren Oberfläche der Abdeckung zugewandten Leuchtelements beleuchtet. An der inneren Oberfläche ist außerdem eine Beschichtung mit Streuwirkung aufgebracht.

Weitere Schalter sind aus den Dokumenten DE 10 2007 018 905 B4, DE 10 2008 062 579 B3, DE 692 22 623 T2 und US 6 909 063 B2 bekannt.

Es ist Aufgabe der Erfindung, einen berührungssensitiven Schalter bereitzustellen, bei welchem mit geringstem Aufwand eine möglichst homogene Ausleuchtung der berührungssensitiven Oberfläche bzw. des zumindest einen graphischen Symbols ermöglicht wird.

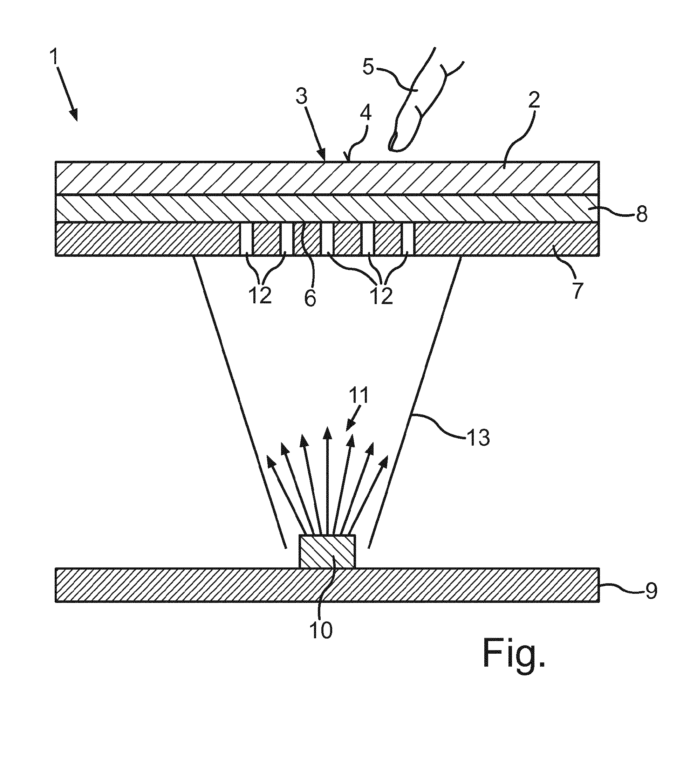

Diese Aufgabe wird erfindungsgemäß durch einen Schalter sowie durch ein Kraftfahrzeug mit den Merkmalen gemäß den jeweiligen unabhängigen Patentansprüchen gelöst. Vorteilhafte Ausführungen der Erfindung sind Gegenstand der abhängigen Patentansprüche, der Beschreibung und der Figur.

Ein erfindungsgemäßer berührungssensitiver Schalter für ein Kraftfahrzeug umfasst eine Abdeckung mit einer berührungssensitiven Oberfläche und zumindest einem graphischen

Symbol. Der Schalter umfasst außerdem eine hinter der Abdeckung angeordnete Trägerplatte, auf welcher zumindest ein kapazitives Sensorelement zum Erfassen einer Berührung der berührungssensitiven Oberfläche angeordnet ist. Beispielsweise kann für jedes graphische Symbol ein separates Sensorelement vorgesehen sein. Der Schalter umfasst außerdem ein Leuchtmittel zum Erzeugen von Licht zum Hinterleuchten der berührungssensitiven Oberfläche bzw. des zumindest einen graphischen Symbols, insbesondere zur Sichtbarmachung des graphischen Symbols bei Nacht und/oder bei Tag mittels der sogenannten Blackpanel-Technologie. Die Trägerplatte ist zumindest im Wesentlichen bzw. in ihrer Materialbeschaffenheit zumindest überwiegend opak ausgebildet und weist eine Mehrzahl von Durchgangsöffnungen auf, durch welche hindurch das Licht des Leuchtmittels die berührungssensitive Oberfläche bzw. das zumindest eine graphische Symbol im Betrieb hinterleuchtet.

Anders als im Stand der Technik gemäß DE 10 2010 062 428 A1 wird somit erfindungsgemäß vorgeschlagen, für die Mehrzahl von Durchgangsöffnungen ein gemeinsames Leuchtmittel einzusetzen, welches beispielsweise auch in einem Abstand zur Trägerplatte liegen kann und ein Licht erzeugt, welches durch die Mehrzahl von Durchgangsöffnungen hindurch die darüber angeordnete berührungssensitive Oberfläche bzw. das zumindest eine graphische Symbol beleuchtet. Durch eine solche Vorgehensweise kann eine besonders homogene Beleuchtung des zumindest einen graphischen Symbols ermöglicht werden, da die Beleuchtung lediglich mit einem einzigen Leuchtmittel erfolgt und somit keine herstellungsbedingte Unterschiede in den optischen Eigenschaften mehrerer Leuchtmittel auftreten können. Außerdem reduziert sich somit die Anzahl der Leuchtmittel erheblich, wodurch wiederum Kosten gespart werden können.

Unter einem graphischen Symbol wird vorliegend ganz allgemein ein Zeichen verstanden, welches über die dem Schalter zugeordnete Funktion informiert. Es kann sich dabei um ein Bildzeichen, ein Wortzeichen, ein Wort-Bild-Zeichen, einen einzelnen Buchstaben oder dergleichen handeln.

Die Abdeckung kann beispielsweise aus einem Kunststoffmaterial ausgebildet sein, wie beispielsweise aus PC-Material. Die Abdeckung kann auch lackiert sein. Vorzugsweise ist die Abdeckung mit dem zumindest einen graphischen Symbol versehen, beispielsweise mittels Lasers. Das zumindest eine graphische Symbol kann beispielsweise als eine Aussparung in einer Beschichtung der Abdeckung bereitgestellt sein, sodass die Abdeckung insgesamt opak ist und lediglich das zumindest eine graphische Symbol mittels des Leuchtelements hinterleuchtet wird.

Werden mehrere graphische Symbole und mehrere Sensorelemente verwendet, so kann jedem graphischen Symbol jeweils eine Mehrzahl von Durchgangsöffnungen in der Trägerplatte zugeordnet sein, durch welche hindurch das jeweilige Symbol hinterleuchtet wird. Für die Symbole kann auch ein gemeinsames Leuchtmittel vorgesehen sein oder es können separate Leuchtmittel für jedes Symbol eingesetzt werden.

Vorzugsweise ist das Leuchtmittel in einem Abstand zur Trägerplatte angeordnet. Dadurch können alle Durchgangsöffnungen hinterleuchtet werden, ohne dass zusätzlich ein Lichtleiter eingesetzt werden muss.

Alternativ kann jedoch auch vorgesehen sein, dass das Leuchtmittel an einer Rückseite der Trägerplatte angeordnet ist und das Licht beispielsweise über einen Lichtleiter und/oder einen Leuchtkasten und/oder Prisma in die Durchgangsöffnungen eingespeist wird.

Es erweist sich als besonders vorteilhaft, wenn zwischen der Abdeckung einerseits und der Trägerplatte andererseits eine Lichtstreuschicht angeordnet ist, welche zum Streuen des Lichts ausgebildet ist. Eine solche transparente Lichtstreuschicht hat den Vorteil, dass die Homogenität der Ausleuchtung der berührungssensitiven Oberfläche weiterhin verbessert werden kann.

Vorzugsweise erstreckt sich die Lichtstreuschicht über der Mehrzahl der Durchgangsöffnungen. Es wird also bevorzugt eine gemeinsame Lichtstreuschicht eingesetzt, welche alle Durchgangsöffnungen gemeinsam verdeckt. Im Vergleich zu mehreren Lichtstreuelementen hat eine solche durchgehende Lichtstreuschicht den Vorteil, dass Lufteinschlüsse zwischen der Abdeckung und der Trägerplatte verhindert werden können, welche dann gegebenenfalls die Funktionsweise der Sensorelemente negativ beeinflussen könnten.

Die Durchgangsöffnungen selbst sind bevorzugt als Hohlöffnungen ausgebildet und somit ungefüllt.

Vorzugsweise liegt die Lichtstreuschicht vollflächig unmittelbar an der Trägerplatte an. Somit verdeckt die Lichtstreuschicht direkt das zumindest eine Sensorelement, sodass der Abstand zwischen dem Sensorelement und der berührungssensitiven Oberfläche minimiert werden kann und die Genauigkeit der kapazitiven Erfassung somit verbessert werden kann.

Vorzugsweise liegt die Lichtstreuschicht auch vollflächig unmittelbar an der Abdeckung an oder ist einstückig mit der Abdeckung ausgebildet. Auch dies minimiert den Abstand zwischen der berührungssensitiven Oberfläche einerseits und dem Sensorelement andererseits.

Insgesamt kann also vorgesehen sein, dass die Lichtstreuschicht in einer Sandwich-Bauweise eng anliegend zwischen der Abdeckung einerseits und der Trägerplatte andererseits angeordnet ist.

In einer Ausführungsform ist vorgesehen, dass das Leuchtmittel auf einer von der Trägerplatte separaten Leiterplatte angeordnet ist, welche in einem Abstand zur Trägerplatte liegt. Somit kann ermöglicht werden, dass das Licht bei jeder Durchgangsöffnung der Trägerplatte im Wesentlichen die gleiche Lichtstärke bzw. Lichtintensität aufweist.

Es erweist sich als besonders vorteilhaft, wenn zwischen dem Leuchtmittel und der Trägerplatte ein Lichtreflektor zum Bündeln des Lichts in Richtung zur Trägerplatte bzw. in Richtung zu den Durchgangsöffnungen angeordnet ist. Ein solcher Lichtreflektor umgibt bevorzugt das Leuchtmittel und dient somit als Führung für das Licht des Leuchtmittels und kann dazu insbesondere die Form eines Kegels aufweisen. Bei entsprechender Ausführung des Lichtreflektors können auch mehrere graphische Symbole mittels eines einzigen Leuchtmittels ausgeleuchtet werden.

Vorzugsweise ist die Trägerplatte als einfache Leiterplatte bzw. Platine ausgebildet. Somit werden der Aufwand und die Kosten weiterhin reduziert. Eine solche Leiterplatte kann zusätzlich auch für die Bestückung von elektronischen Bauelementen für die Auswertung der elektrischen Kapazität genutzt werden.

Ein erfindungsgemäßes Kraftfahrzeug, insbesondere ein Personenkraftwagen, umfasst einen erfindungsgemäßen Schalter. Der Schalter kann beispielsweise zum Bedienen einer Klimaanlage genutzt werden.

Weitere Merkmale der Erfindung ergeben sich aus den Ansprüchen, der Figur und der Figurenbeschreibung. Alle vorstehend in der Beschreibung genannten Merkmale und Merkmalskombinationen sowie die nachfolgend in der Figurenbeschreibung genannten und/oder in der Figur alleine gezeigten Merkmale und Merkmalskombinationen sind nicht nur in der jeweils angegebenen Kombination, sondern auch in anderen Kombinationen oder aber in Alleinstellung verwendbar.

Die Erfindung wird nun anhand eines bevorzugten Ausführungsbeispiels sowie unter Bezugnahme auf die beigefügte Zeichnung näher erläutert. Dabei veranschaulicht die einzige Figur in schematischer Darstellung einen berührungssensitiven Schalter gemäß einer Ausführungsform der Erfindung.

Ein in der Figur dargestellter Schalter 1 ist zum Bedienen von Funktionseinrichtungen eines Kraftfahrzeugs konzipiert, beispielsweise einer Klimaanlage. Der berührungssensitive Schalter 1 umfasst eine frontseitige Abdeckung 2, welche einerseits als Verkleidung dient und andererseits mit zumindest einem graphischen Symbol 3 versehen werden kann, welches beispielsweise als Aussparung in einer Beschichtung bzw. einer Maske bereitgestellt sein kann. Durch das graphische Symbol 3 wird die Funktion gekennzeichnet, welche durch den Schalter 1 aktiviert bzw. deaktiviert werden kann. Die Abdeckung 2 kann beispielsweise aus lackiertem PC-Material gebildet sein, wobei das Symbol 3 als eine Aussparung in der Lackschicht angebracht werden kann, beispielsweise mittels Lasers. Die Abdeckung 2 weist eine äußere Oberfläche 4 auf, welche auch die Oberfläche des graphischen Symbols 3 darstellen kann. Um den Schalter 1 zu betätigen, braucht der Benutzer die berührungsempfindliche Oberfläche 4 mit einem Finger 5 zu berühren.

Um die Berührung mit dem Finger 5 zu detektieren, ist zumindest ein Sensorelement 6 vorgesehen, welches in Form einer metallischen Schicht, zum Beispiel aus Kupfer, auf einer Trägerplatte 7 angeordnet ist. Die Trägerplatte 7 ist hinter der Abdeckung 2 und somit auf einer der Oberfläche 4 gegenüberliegenden Seite der Abdeckung 2 angeordnet und erstreckt sich beispielsweise parallel zur Abdeckung 2. Im Ausführungsbeispiel ist die ebene Trägerplatte 7 als Leiterplatte bzw. Platine ausgebildet. Die Abdeckung 2 kann auch dreidimensional bzw. gekrümmt ausgebildet sein. Bei dieser Ausführungsform ist die Trägerplatte 7 dann insbesondere nicht parallel zur Abdeckung 2 angeordnet.

Eng anliegend befindet sich zwischen der ebenen oder gekrümmten Abdeckung 2 und der ebenen oder gekrümmten Trägerplatte 7 in Sandwich-Bauweise eine ebene oder gekrümmte Lichtstreuschicht 8, welche aus einem lichtstreuenden Material gebildet ist. Die Lichtstreuschicht 8 liegt einerseits an der Trägerplatte 7 und andererseits an der Abdeckung 2 an und kann alternativ auch einstückig bzw. integral mit der Abdeckung 2 ausgebildet sein.

Das genannte Sensorelement 6 ist in Überdeckung bzw. in gegenseitiger Überlappung mit dem graphischen Symbol 3 angeordnet. Durch Berühren des graphischen Symbols 3 kann somit die Funktion aktiviert bzw. deaktiviert werden.

Auf einer separaten Leiterplatte 9 ist ein Leuchtmittel 10 angeordnet, welches beispielsweise als LED ausgebildet ist. Die Leiterplatte 9 befindet sich in einem Abstand zur Trägerplatte 7 und erstreckt sich dabei beispielsweise parallel oder nicht-parallel dazu. Das Leuchtmittel 10 kann Licht 11 erzeugen, mit welchem das zumindest eine graphische Symbol 3 auf der Oberfläche 4 hinterleuchtet wird. Zu diesem Zwecke sind in der Trägerplatte 7 eine Vielzahl von Durchgangsöffnungen 12 ausgebildet, durch welche hindurch das zumindest eine graphische Symbol 3 auf der Oberfläche 4 durch das Licht 11 hinterleuchtet wird. Die Durchgangsöffnungen 12 werden also durch das Licht 11 des gemeinsamen Leuchtmittels 10 durchstrahlt und die Oberfläche 4 bzw. das zumindest eine Symbol 3 ausgeleuchtet. Bis zur Lichtstreuschicht 8 breitet sich das Licht 11 über die Luft als Ausbreitungsmedium aus.

Um eine Bündelung des Lichts 11 in Richtung zu den Durchgangsöffnungen 12 bzw. zur Trägerplatte 7 hin zu erreichen, ist ein kegelförmiger Lichtreflektor 13 um das Leuchtmittel 10 herum angeordnet, der sich zwischen der Leiterplatte 9 einerseits und der Trägerplatte 7 andererseits erstreckt und einen in Richtung zur Trägerplatte 7 hin größer werdenden Durchmesser aufweist. Dies bedeutet, dass die Drehsymmetrieachse des Lichtreflektors 13 senkrecht zur Leiterplatte 9 und zur Trägerplatte 7 verläuft und insbesondere mit der optischen Achse des Leuchtmittels 10 zusammenfällt. Der Lichtreflektor 13 kann beispielsweise ein Spiegelelement sein, in dessen Innenraum das Licht 11 in Richtung zur Trägerplatte 7 hin geführt wird. Der Lichtreflektor 13 kann beispielsweise an der Leiterplatte 9 und/oder an der Trägerplatte 7 befestigt sein.

Alternativ kann jedoch auch vorgesehen sein, dass das Leuchtmittel 10 an der Rückseite der Trägerplatte 7 angeordnet ist. Das Licht kann dann beispielsweise über einen Lichtleiter und/oder einen Leuchtkasten und/oder Prisma in die Durchgangsöffnungen 12 eingespeist werden.

Damit das Licht 11 auch durch das Sensorelement 6 hindurch das zumindest eine graphische Symbol 3 beleuchten kann, können entsprechende Durchgangsöffnungen 12 auch in dem Sensorelement 6 vorgesehen sein, die an gleicher Stelle wie die Durchgangsöffnungen 12 der Trägerplatte 7 angeordnet sind. Das Sensorelement 6 kann aber auch aus einem transparenten und elektrisch leitfähigen Material - beispielsweise elektrisch leitfähiger Folie - gebildet sein, ohne dass dann Durchgangsöffnungen benötigt werden.

Die Anzahl, Anordnung und Position der Durchgangsöffnungen 12 werden unter Berücksichtigung der jeweiligen optischen Eigenschaften der Beleuchtung und der elektrischen Eigenschaften des Sensorelements 6 festgelegt. Auch die Dicke der Lichtstreuschicht 8 kann abhängig von den benötigten optischen Eigenschaften gewählt werden.

Insgesamt wird somit eine besonders homogene Ausleuchtung des zumindest einen graphischen Symbols mit lediglich einem Leuchtmittel 10 ermöglicht. Bei Ausführung des Lichtreflektors 13 als eine größere Lichtbox können auch mehrere graphische Symbole 3 und somit ein größerer Bereich der Oberfläche 4 der Abdeckung 2 mit lediglich einem Leuchtmittel 10 oder optional mit mehreren Leuchtmitteln 10 ausgeleuchtet werden.

## Patentansprüche

1. Berührungssensitiver Schalter (1) für ein Kraftfahrzeug, mit:
- einer Abdeckung (2) mit einer berührungssensitiven Oberfläche (4) und mit zumindest einem grafischen Symbol (3),
- einer hinter der Abdeckung (2) angeordneten Trägerplatte (7), auf welcher zumindest ein kapazitives Sensorelement (6) zum Erfassen einer Berührung der berührungssensitiven Oberfläche (4) angeordnet ist, und
- einem Leuchtmittel (10) zum Erzeugen von Licht (11) zum Hinterleuchten der berührungssensitiven Oberfläche (4),
**dadurch gekennzeichnet, dass**
die Trägerplatte (7) opak ausgebildet ist und eine Mehrzahl von Durchgangsöffnungen (12) aufweist, durch welche hindurch das Licht (11) des gemeinsamen Leuchtmittels (10) die berührungssensitive Oberfläche (4) im Betrieb hinterleuchtet.

2. Schalter (1) nach Anspruch 1,
**dadurch gekennzeichnet, dass**
das Leuchtmittel (10) in einem Abstand zur Trägerplatte (7) angeordnet ist.

3. Schalter (1) nach Anspruch 1 oder 2,
**dadurch gekennzeichnet, dass**
zwischen der Trägerplatte (7) und der Abdeckung (2) eine Lichtstreuschicht (8) angeordnet ist, welche zum Streuen des Lichts (11) ausgebildet ist.

4. Schalter (1) nach Anspruch 3,
**dadurch gekennzeichnet, dass**
sich die Lichtstreuschicht (8) über der Mehrzahl der Durchgangsöffnungen (12) erstreckt.

5. Schalter (1) nach Anspruch 3 oder 4,
**dadurch gekennzeichnet, dass**
die Lichtstreuschicht (8) unmittelbar an der Trägerplatte (7) anliegt.

6. Schalter (1) nach einem der Ansprüche 3 bis 5,
**dadurch gekennzeichnet, dass**
die Lichtstreuschicht (8) unmittelbar an der Abdeckung (2) anliegt oder einstückig mit der Abdeckung (2) ausgebildet ist.

7. Schalter (1) nach einem der vorhergehenden Ansprüche,
**dadurch gekennzeichnet, dass**
das Leuchtmittel (10) auf einer von der Trägerplatte (7) separaten Leiterplatte (9) angeordnet ist, welche in einem Abstand zur Trägerplatte (7) angeordnet ist.

8. Schalter (1) nach einem der vorhergehenden Ansprüche,
**dadurch gekennzeichnet, dass**
zwischen dem Leuchtmittel (10) und der Trägerplatte (7) ein Lichtreflektor (13) zum Bündeln des Lichts (11) in Richtung zur Trägerplatte (7) angeordnet ist.

9. Schalter (1) nach einem der vorhergehenden Ansprüche,
**dadurch gekennzeichnet, dass**
die Trägerplatte (7) als Leiterplatte ausgebildet ist.

10. Kraftfahrzeug mit einem berührungssensitiven Schalter (1) nach einem der vorhergehenden Ansprüche.
